# FASCICULE DE BREVET EUROPEEN

(11) **EP 3 731 613 B1**
(45) Date de publication et mention de la délivrance du brevet: **21.12.2022**
(21) Numéro de dépôt: 20181973.7
(22) Date de dépôt: 24.06.2020
(51) Int. Cl.: H05K 7/20, F28D 15/02, H01L 23/427, F28F 13/12, H01L 21/48

(54) **PROCÉDÉ D'INTÉGRATION D'UN CALODUC À UNE PLAQUE DESTINÉE À FORMER UN CONTACT ÉLECTRIQUE**
VERFAHREN ZUR INTEGRATION EINES WÄRMEÜBERTRAGUNGSROHRS IN EINE PLATTE, DIE EINEN ELEKTRISCHEN KONTAKT BILDEN SOLL
METHOD FOR INTEGRATING A HEAT PIPE INTO A PLATE INTENDED FOR FORMING AN ELECTRICAL CONTACT

(30) Priorité: 28.06.2019 FR 1907133; 25.04.2019 FR 1904362
(43) Date de publication de la demande: 28.10.2020
(73) Titulaire: Commissariat à l'énergie atomique et aux énergies alternatives, 75015 Paris (FR)
(72) Inventeur: MARIOTTO, Mathieu, 38054 GRENOBLE CEDEX 09 (FR); CWICKLINSKI, Grégory, 38054 GRENOBLE CEDEX 09 (FR); GRUSS, Jean-Antoine, 38054 GRENOBLE CEDEX 09 (FR)
(74) Mandataire: Brevalex

(56) Documents cités:
- US-A- 5 826 645
- US-A1- 2011 162 206
- US-A1- 2016 282 054

## Description

### DOMAINE TECHNIQUE

La présente invention se rapporte au domaine de la gestion thermique, et notamment des transferts thermiques, pour le refroidissement d'appareils électriques.

En particulier, la présente invention se rapporte à la gestion thermique dans une section confinée d'un appareil électrique. La présente invention met donc en œuvre un caloduc intégré directement à une pièce ou plaque métallique formant un contact et/ou une liaison électrique. La pièce ou la plaque est notamment non plane.

### ÉTAT DE LA TECHNIQUE ANTÉRIEURE

Les caloducs, bien connus de l'homme du métier, sont des systèmes thermiques mis en œuvre pour le refroidissement de dispositifs.

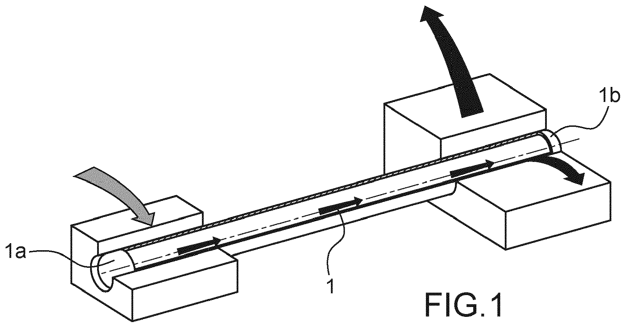

Un caloduc, tel qu'illustré à la figure 1, comprend à cet égard une enceinte hermétique, par exemple sous forme de tube creux, qui renferme un fluide destiné à être dans un état d'équilibre liquide-vapeur.

En fonctionnement, une extrémité la du caloduc 1 est en contact avec un élément à refroidir.

Le fluide à l'état liquide au niveau de l'extrémité la se vaporise en absorbant l'énergie thermique émise par l'élément à refroidir, et circule donc le long du caloduc pour atteindre une autre extrémité 1b dudit caloduc au niveau de laquelle son énergie thermique est dissipée de sorte que ledit fluide retourne à l'état liquide.

Un dissipateur thermique, par exemple un dissipateur à ailettes, est généralement agencé au niveau de l'extrémité 1b.

L'intégration du caloduc à l'élément à refroidir s'effectue généralement au moyen d'une interface, et notamment d'une platine, destinée à assurer un contact thermique entre le caloduc et ledit élément.

En particulier, une section, dite section chaude, du caloduc qui s'étend à partir de l'extrémité 1a, est insérée dans un orifice usiné dans l'interface.

Le maintien mécanique du caloduc dans la platine peut être obtenu de diverses manières parmi lesquelles on peut citer :
- un montage en force ;
- un montage par écrasement ;
- un montage par application d'une pression interne dans le caloduc permettant de plaquer les parois de la section chaude contre celles de l'orifice ménagé dans l'interface ;
- un montage par olivage ;
- un montage par brasage ;
- un montage par collage.

Toutefois ces techniques ne sont pas satisfaisantes.

En effet, le contact thermique entre l'élément à refroidir et le caloduc, médié par la platine, n'est pas optimum et dégrade d'autant l'efficacité du refroidissement de l'élément à refroidir.

L'optimisation de ce contact thermique reste par ailleurs compliquée à mettre œuvre à un coût acceptable.

En outre, dès lors qu'il existe une contrainte d'espace et/ou que la zone à refroidir n'est pas plane, l'emploi d'un caloduc intégré à une platine reste compliqué, voire impossible à mettre en œuvre.

Une telle contrainte existe notamment dès lors que l'élément à refroidir est un appareil électrique, et plus particulièrement lorsqu'il s'agit de refroidir ce dernier au niveau de bornes électriques ou d'éléments de connexion électriques.

Ces éléments représentent généralement des points chauds au niveau desquels la gestion thermique présente un réel problème.

Les documents US 5 826 645, US 2016/282054 et US 2011/162206 divulguent chacun un procédé d'intégration d'un caloduc. Toutefois, les procédés divulgués dans ces documents, dans la mesure où ils ne permettent pas de répondre favorablement aux problématiques décrites ci-avant, ne sont pas non satisfaisants.

Un but de la présente invention est donc de proposer un procédé d'intégration d'un caloduc avec un élément de contact électrique non plan.

Un autre but de la présente invention est de proposer un procédé d'intégration d'un caloduc au plus près d'un point chaud d'un équipement électrique.

Un autre but de la présente invention est de proposer un procédé permettant d'optimiser le contact thermique entre un caloduc et un élément à refroidir.

### EXPOSÉ DE L'INVENTION

Les buts de l'invention sont, au moins en partie, atteints par un procédé d'intégration d'un caloduc à une plaque selon les termes de la revendication 1.

En particulier, les buts de l'invention sont, au moins en partie, atteints par un procédé d'intégration d'un caloduc à une plaque destinée à former un contact électrique au sein d'un ou plusieurs appareils électriques, le procédé comprenant :
a) une étape de formation d'une gorge, délimitée par une surface de contact, sur une face principale d'une plaque métallique ;
b) une étape de positionnement d'une première section d'un tube de caloduc, de diamètre D, dans la gorge, la première section s'étendant à partir d'une première extrémité dudit tube et est délimitée par une première surface ;
c) une étape de pliage de la plaque de manière à refermer la gorge et ainsi enserrer la première section dans ladite gorge, le pliage étant en outre exécuté de sorte que la surface de contact soit intégralement en contact avec la première surface.

Selon un mode de mise en œuvre, l'étape c) est exécutée de sorte que lors du pliage les deux bords latéraux de la gorge se déforment et viennent sertir la première section.

Selon un mode de mise en œuvre, l'étape c) de pliage est exécuté au moyen d'un poinçon exerçant une force au niveau de la première section, avantageusement, l'extrémité du poinçon en contact avec la première section lors de l'exécution de l'étape c) présente une forme conforme à ladite première section.

Selon un mode de mise en œuvre, lors de l'exécution de l'étape c), la plaque métallique est posée sur un guide présentant une section en V et dont l'ouverture définie l'angle de pliage de ladite plaque.

Selon un mode de mise en œuvre, l'angle θ de pliage est compris entre 45° et 135°.

Selon un mode de mise en œuvre, la gorge présente une largeur comprise entre 1,25 et 2,5 fois le diamètre D.

Selon un mode de mise en œuvre, la gorge présente une profondeur comprise entre 0,3 et 0,9 fois le diamètre D.

Selon un mode de mise en œuvre, la gorge présente un rayon de courbure compris entre 0,25 et 2 fois le rayon R du tube.

Selon un mode de mise en œuvre, l'épaisseur de la plaque métallique est inférieure au diamètre D.

Selon un mode de mise en œuvre, la gorge est formée selon au moins une des techniques parmi : usinage, perçage, découpe au jet d'eau, découpe laser, gravure chimique.

Selon un mode de mise en œuvre, la plaque métallique ainsi que la gorge sont formées par fabrication additive.

Selon un mode de mise en œuvre, avant l'étape de pliage, le tube présente un remplissage configuré pour prévenir toute déformation du tube lors de l'étape b) de pliage.

Selon un mode de mise en œuvre, le remplissage comprend un gaz.

Selon un mode de mise en œuvre, le remplissage comprend une poudre, notamment du sable.

Selon un mode de mise en œuvre, un fluide destiné à assurer le transport de chaleur dans le tube du caloduc est injecté dans ledit tube après l'étape c) de pliage.

Selon un mode de mise en œuvre, le tube est rempli d'un fluide destiné à assurer le transport de chaleur dans le tube du caloduc est injecté dans ledit tube avant l'étape b).

Selon un mode de mise en œuvre, le tube comprend un insert dans son volume interne destiné à appliquer une force contre la surface interne du tube et limiter toute déformation du tube lors de l'exécution de l'étape c).

Selon un mode de mise en œuvre, l'insert comprend un axe qui s'étend selon la direction d'extension du tube, et à partir duquel s'étendent des ailettes qui exercent une force contre la paroi interne du tube.

Selon un mode de mise en œuvre, les ailettes sont en flexion.

Selon un mode de mise en œuvre, l'insert comprend un métal.

Selon un mode de mise en œuvre, un dispositif de dissipation de chaleur, notamment un dissipateur à ailettes, est disposé au niveau d'une seconde extrémité, opposée à la première extrémité, du tube.

Selon un mode de mise en œuvre, plaque est intégrée à un appareil électrique, à l'issue de l'étape c), afin d'assurer une connexion électrique.

### BRÈVE DESCRIPTION DES DESSINS

D'autres caractéristiques et avantages apparaîtront dans la description qui va suivre d'un procédé d'intégration d'un caloduc à une plaque selon l'invention, donnés à titre d'exemples non limitatifs, en référence aux dessins annexés dans lesquels :
La figure 1 est une illustration d'un caloduc et de son fonctionnement ;
Les figures 2a, 2b, 2c, 2d sont des illustrations, en perspective, des différentes étapes mises en œuvre dans le cadre de la présente invention ;
Les figures 3a, 3b, 3c, 3d sont des illustrations, selon un plan de coupe transversal à la gorge, des différentes étapes mises en œuvre dans le cadre de la présente invention ;
La figure 4 est une représentation schématique du sertissage du tube du caloduc par les bords de la gorge ;
Les figures 5a, 5b illustrent de manière schématique un exemple de mise en œuvre de l'étape c), respectivement avant et après pliage, mettant notamment en œuvre un poinçon et un guide de pliage sur lequel repose la plaque par une face opposée à la face sur laquelle la gorge est formée ;
La figure 6 est une représentation schématique selon une vue en perspective d'un insert susceptible d'être mis en œuvre dans la cadre de la présente invention ;
La figure 7 est une représentation schématique selon un plan de coupe transversal du tube dans lequel est inséré l'insert avec des ailettes en flexion, les flèches indiquant les directions de poussée des différentes ailettes ;
La figure 8 est une photographie d'un tube de caloduc intégré à une plaque selon les termes de la présente invention.

### EXPOSÉ DÉTAILLÉ DE MODES DE RÉALISATION PARTICULIERS

La présente invention concerne un procédé d'intégration d'un caloduc et d'une plaque destinée à former un contact électrique au sein d'un appareil électrique.

Le caloduc est directement dans le volume de plaque à refroidir. Il est notamment intégré à la plaque via une gorge. Le pliage permet notamment d'enserrer le caloduc dans la gorge.

Le procédé selon la présente invention ne nécessite aucun recours à une platine intermédiaire, et permet d'intégrer le caloduc au plus près de la ou des sources chaudes de l'appareil.

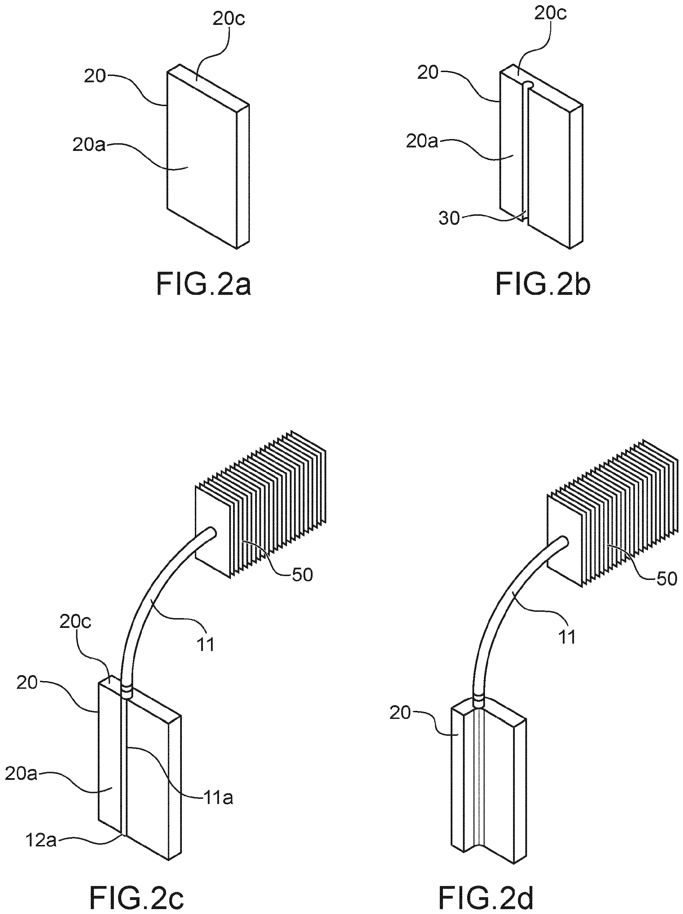

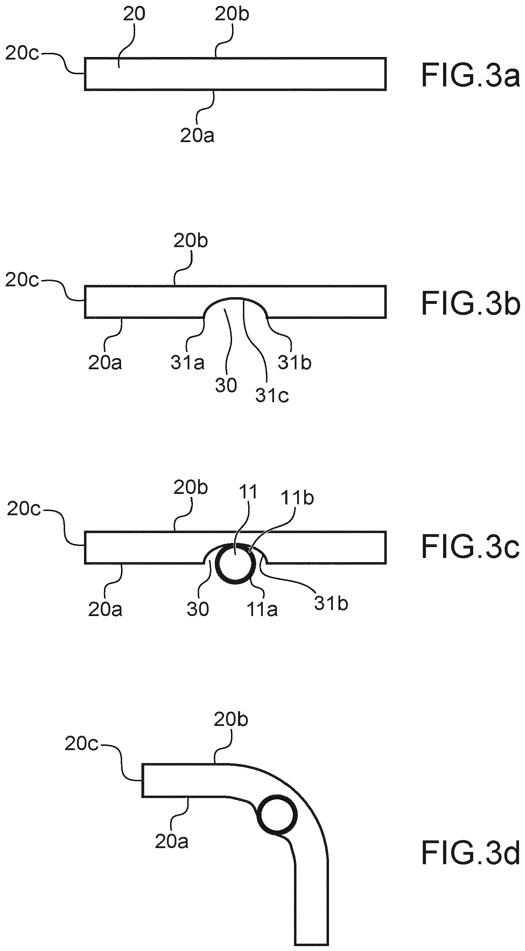

Les figures 2a à 2d et 3a à 3d illustrent le procédé d'intégration d'un caloduc 10 à une plaque 20 destinée à former un contact électrique au sein d'un ou plusieurs appareils électriques.

La plaque 20 comprend une espèce métallique, et est notamment un conducteur thermique. La plaque 20 peut en particulier comprendre du cuivre ou de l'aluminium. Toutefois, l'invention ne doit pas être limitée à ces deux seuls matériaux, et l'homme du métier pourra considérer tout autre métal susceptible de convenir en fonction de l'application visée.

La plaque 20 est plane et comprend deux faces, dites faces principales 20a et 20b, parallèles entre elles et reliées par un contour 20c (figures 2a et 3a).

La plaque 20 présente une épaisseur E définie par la distance entre les deux faces principales 20a et 20b.

Le procédé selon la présente invention comprend une étape a) de formation d'une gorge 30 sur la face principale 20a (figures 2b et 3b).

Par « gorge », on entend une partie évidée, étroite et allongée. La gorge selon la présente invention comprend deux bords 31a et 31b qui s'étendent selon la direction d'élongation de ladite gorge. La gorge est également délimitée par une surface, dite surface de contact 31c, entre les deux bords 31a et 31b.

La gorge 30 peut être formée par une technique de soustraction de matière.

Par exemple, l'étape b) peut être exécutée selon l'une des méthodes choisie parmi : usinage, perçage, découpe au jet d'eau, découpe laser, gravure chimique.

De manière alternative, la plaque 20 pourvue de la gorge 30 peut être formée par une technique de fabrication additive.

Le procédé selon la présente invention comprend également une étape b) de positionnement, dans la gorge 30, d'une première section 11a d'un tube 11 de caloduc 10 (figure 2c et 3c).

La première section 11a s'étend notamment à partir d'une extrémité du tube 11, dite première extrémité 12a. La première section 11a est par ailleurs délimité par une section de la surface externe du tube 11, dite première surface 11b.

Selon une première variante de la présente invention, le tube peut comprendre, avant exécution de l'étape b), un fluide destiné à assurer les échanges et transport de chaleur.

Selon une seconde variante de l'invention, le tube ne comprend pas le fluide destiné à assurer les échanges et transport de chaleur. Le tube peut en revanche comprendre un remplissage configuré pour prévenir toute déformation du tube lors d'une étape c) de pliage explicité ci-après et représentée aux figures 2d et 3d.

L'étape c) de pliage de la plaque 20 est exécutée de manière à refermer la gorge 30 et ainsi enserrer la première section 11a dans ladite gorge 30.

Plus particulièrement, l'étape c) de pliage de la plaque 20 peut être exécuté de sorte que la surface de contact 31c délimitant la gorge 30 soit intégralement en contact avec de la première surface 11b délimitant la première section 11a.

Cet aspect permet ainsi d'optimiser des échanges thermiques susceptibles d'intervenir entre la plaque 20 et le tube 11.

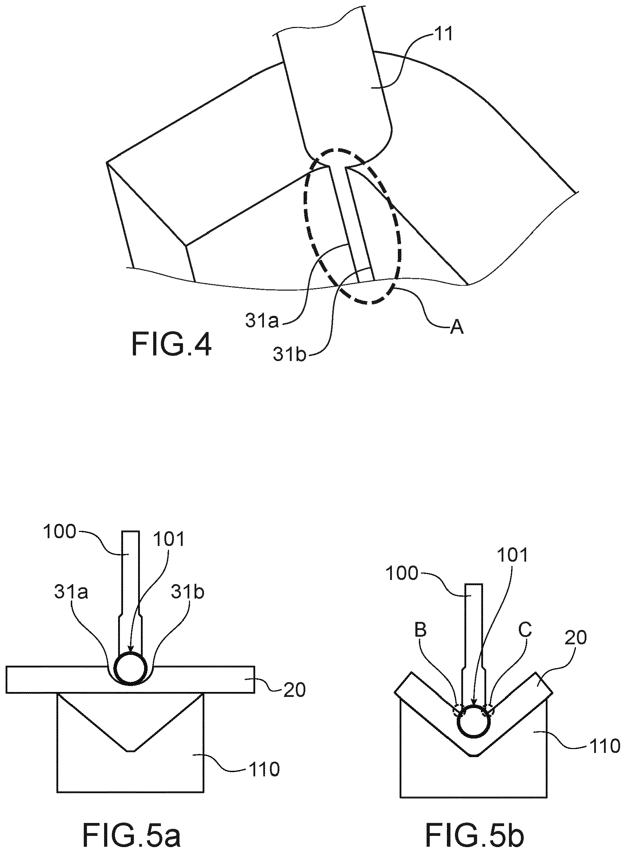

En outre, l'étape c) peut être exécutée de sorte que les bords 31a et 31b de la gorge se déforment et viennent sertir la première section 11a. Plus particulièrement, le sertissage comprend une déformation des bords 31a et 31b de la gorge 30 de sorte que ces derniers viennent épouser le profil du tube 11. La figure 4 illustre l'effet du sertissage du tube 11 par les bords 31a et 31b de la gorge au niveau de la zone A. Plus particulièrement, lors du sertissage, les bords 31a et 31b peuvent opérer une jonction et ainsi refermer la gorge 30 sur le tube 11.

L'étape c) de pliage peut être exécutée en exerçant une force sur le tube 11 (par exemple au niveau de la première section 11a) au moyen d'un poinçon 100 (figures 5a et 5b).

Selon cet exemple particulier, la plaque 20 repose sur un support 110 qui présente un profil transversal en forme de V et dont l'ouverture définie l'angle de pliage de la plaque 20 à l'issue de l'étape c).

Lors de l'exécution de l'étape c), le poinçon 100 est mis en contact avec le tube 11, notamment avec la première section 11a, et une force de poussée est alors appliquée audit poinçon 100 de sorte que ce dernier force le pliage de la plaque. La poussée cesse dès lors que la plaque est pliée de manière conforme au support 110.

L'extrémité 101 du poinçon 100 en contact avec le tube 11 peut avantageusement présenter une forme conforme à la surface externe du tube 11.

La surface de contact entre le poinçon 100 et la première section 11a peut être ajustée de manière à permettre la déformation des bords 31a et 31b de la gorge 30, et plus particulièrement autoriser une remontée (le sertissage) desdits bords 31a et 31b par déformation sur la surface externe de la première section (zones « B » et « C » figure 5b).

L'angle θ de pliage peut être compris entre 45 ° et 135 °, et par exemple égal à 90°.

Cet angle de pliage peut notamment être imposé par l'angle d'ouverture en V du support 110 illustré aux figures 5a et 5b.

L'épaisseur de la plaque 20 est avantageusement inférieure au diamètre D.

Les inventeurs ont remarqué que la qualité du contact entre la première section et la gorge à l'issue de l'étape c) pouvait dépendre des caractéristiques géométriques de la gorge.

Plus particulièrement, l'ajustement de ces dernières en fonction du diamètre D du tube 11 considéré permet avantageusement d'optimiser le contact thermique entre ledit tube 11 et la plaque 20.

Notamment, la gorge 30 présente avantageusement une largeur comprise entre 1,25 et 2,5 fois le diamètre D du tube 11.

De manière complémentaire ou alternative, la gorge 30 présente une profondeur comprise entre 0,3 et 0,9 fois le diamètre D du tube 11.

Toujours de manière complémentaire ou alternative à l'une et/ou l'autre des caractéristiques géométriques reprises ci-avant, la gorge présente un rayon de courbure à partir de l'un et l'autre des bords 31a et 31b compris entre 0,25 et 2 fois le rayon R du tube.

Par « rayon de courbure à partir d'un bord », on entend le rayon de courbure d'une section du profil transversal de la gorge et qui s'étend à partir dudit bord.

Selon la première variante présentée précédemment, un fluide destinée à assurer le transport de chaleur est présent dans le volume interne du tube 11 formant le caloduc 10.

Selon la seconde variante présentée précédemment, le tube 11 peut comprendre un remplissage configuré pour prévenir toute déformation du tube lors d'une étape c) de pliage.

Ce remplissage peut notamment comprendre une poudre, par exemple du sable, ou encore un arbre de diamètre externe légèrement inférieur au diamètre interne du tube (par inférieur, on entend entre 5% à 15% inférieur au diamètre interne du tube).

L'étape c) est alors suivie d'une étape de retrait du remplissage et éventuellement de nettoyage de l'intérieur du tube 11.

Le fluide destiné à assurer le transport de chaleur dans le tube 11 du caloduc 10 peut être injecté dans ledit tube.

Quel que soit la variante considérée, le tube 11 peut comprendre un insert 40 introduit dans son volume interne avant ou après l'exécution de l'étape c) de pliage.

L'insert 40 est notamment destiné à appliquer une force contre la surface interne du tube et limiter toute déformation du tube lors de l'exécution de l'étape c).

En d'autres termes, l'insert 40 aide au maintien de la surface interne du tube 11 de manière à éviter la déformation de ce dernier lors de l'exécution de l'étape c).

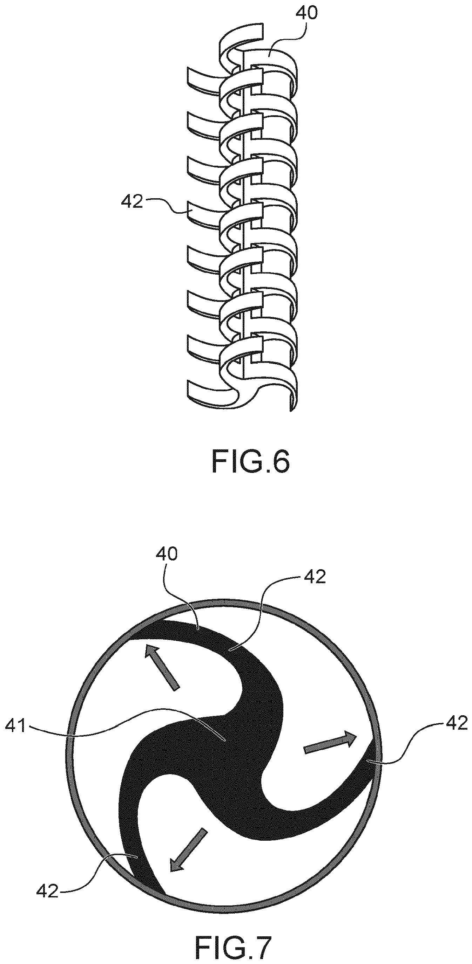

L'insert 40, tel que représenté aux figures 6 et 7, comprend un axe 41 qui s'étend selon la direction d'extension du tube 11, et à partir duquel s'étendent des ailettes 42 courbées qui exercent une force contre la paroi interne du tube.

En d'autres termes, les ailettes 42 sont en flexion.

Les ailettes peuvent avantageusement être agencées en rangées qui s'étendent le long de l'arbre, et régulièrement espacées le long de chaque rangée.

Par exemple, l'insert peut comprendre trois rangées d'ailettes.

L'insert peut comprendre un métal, par exemple du cuivre, et ainsi participer au transport de chaleur et par voie de conséquence améliorer les performances du caloduc. La mise en œuvre de l'insert permet notamment d'améliorer la résistance thermique à l'évaporateur (sa conductance sera meilleure), et également d'augmenter la limite d'ébullition du dispositif (dryout de la paroi et interruption de la transmission du flux thermique entre la source chaude et le fluide caloporteur du caloduc).

Le procédé selon la présente invention peut également comprendre l'installation d'un dispositif de dissipation de chaleur 50, notamment un dissipateur à ailettes, au niveau d'une seconde extrémité, opposée à la première extrémité, du tube.

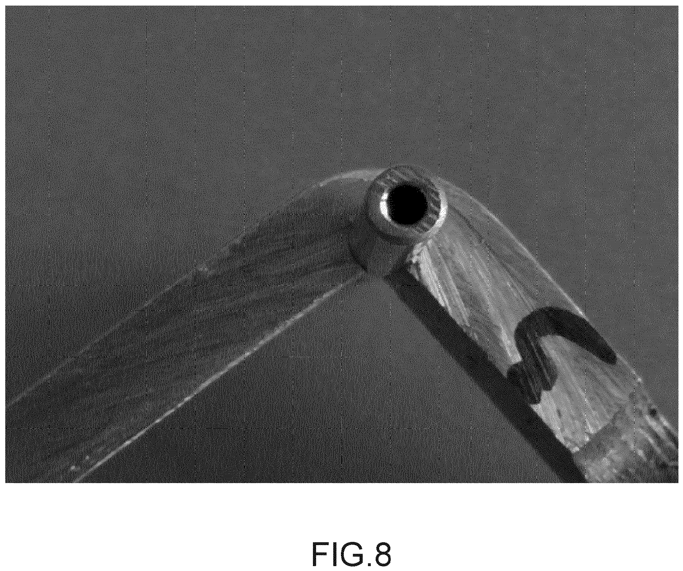

La figure 8 est une photographie d'un tube de caloduc intégré à une plaque selon les termes de la présente invention.

Enfin le procédé peut comprendre l'intégration de la plaque pliée et pourvue du caloduc dans un appareil électrique afin d'assurer une connexion électrique.

La présente invention permet ainsi d'intégrer un caloduc au plus près d'un élément à refroidir d'un appareil électrique malgré les contraintes d'espace et/ou de non planéité de ladite source susceptible d'apparaître.

Par ailleurs, le procédé selon la présente invention permet d'optimiser le contact thermique entre le caloduc et l'élément à refroidir.

## Revendications

1. Procédé d'intégration d'un caloduc (10) à une plaque (20) destinée à former un contact électrique au sein d'un ou plusieurs appareils électriques, le procédé comprenant :
a) une étape de formation d'une gorge (30), délimitée par une surface de contact (31c), sur une face principale (20a) d'une plaque (20) métallique ;
b) une étape de positionnement d'une première section (11a) d'un tube (11) de caloduc (10), de diamètre D, dans la gorge (30), la première section (11a) s'étendant à partir d'une première extrémité (12a) dudit tube (11) et est délimitée par une première surface (11b) ;
c) une étape de pliage de la plaque (20) de manière à refermer la gorge (30) et ainsi enserrer la première section (11a) dans ladite gorge (30), le pliage étant en outre exécuté de sorte que la surface de contact (31c) soit intégralement en contact avec la première surface (11b), avantageusement, l'étape c) est exécutée de sorte que lors du pliage, les deux bords (31a, 31b) latéraux de la gorge (30) se déforment et viennent sertir la première section (11a).

2. Procédé selon la revendication 1, dans lequel l'étape c) de pliage est exécuté au moyen d'un poinçon exerçant une force au niveau de la première section (11a), avantageusement, l'extrémité (101) du poinçon (100) en contact avec la première section (11a) lors de l'exécution de l'étape c) présente une forme conforme à ladite première section (11a), encore plus avantageusement lors de l'exécution de l'étape c), la plaque (20) métallique est posée sur un support (110) présentant une section en V et dont l'ouverture définie l'angle de pliage de ladite plaque (20).

3. Procédé selon la revendication 1 ou 2, dans lequel l'angle θ de pliage est compris entre 45 ° et 135 °.

4. Procédé selon l'une des revendications 1 à 3, dans lequel la gorge (30) présente une largeur comprise entre 1,25 et 2,5 fois le diamètre D.

5. Procédé selon l'une des revendications 1 à 4, dans lequel la gorge (30) présente une profondeur comprise entre 0,3 et 0,9 fois le diamètre D.

6. Procédé selon l'une des revendications 1 à 5, dans lequel la gorge (30) présente un rayon de courbure à partir de l'un et l'autre des bords (31a, 31b) de ladite gorge (30) compris entre 0,25 et 2 fois le rayon R du tube (11).

7. Procédé selon l'une des revendications 1 à 6, dans lequel l'épaisseur de la plaque (20) métallique est inférieure au diamètre D.

8. Procédé selon l'une des revendications 1 à 7, dans lequel la gorge (30) est formée selon au moins une des techniques parmi : usinage, perçage, découpe au jet d'eau, découpe laser, gravure chimique.

9. Procédé selon l'une des revendications 1 à 7, dans lequel la plaque (20) métallique ainsi que la gorge (30) sont formées par fabrication additive.

10. Procédé selon l'une des revendications 1 à 9, dans lequel, avant l'étape de pliage, le tube (11) présente un remplissage configuré pour prévenir toute déformation du tube (11) lors de l'étape c) de pliage, avantageusement, le remplissage comprend un gaz ou une poudre, et notamment du sable.

11. Procédé selon l'une des revendications 1 à 10, dans lequel un fluide destiné à assurer le transport de chaleur dans le tube (11) du caloduc (10) est injecté dans ledit tube (11) après l'étape c) de pliage.

12. Procédé selon l'une des revendications 1 à 9, dans lequel le tube (11) est rempli d'un fluide destiné à assurer le transport de chaleur dans le tube (11) du caloduc (10) est injecté dans ledit tube (11) avant l'étape b), avantageusement, le tube (11) comprend un insert (40) dans son volume interne destiné à appliquer une force contre la surface interne du tube (11) et limiter toute déformation du tube (11) lors de l'exécution de l'étape c), plus avantageusement, l'insert (40) comprend un axe (41) qui s'étend selon la direction d'extension du tube (11), et à partir duquel s'étendent des ailettes courbées qui exercent une force contre la paroi interne du tube (11), encore plus avantageusement les ailettes sont en flexion.

13. Procédé selon l'une des revendications 1 à 12, dans lequel un dispositif de dissipation de chaleur, notamment un dissipateur à ailettes, est disposé au niveau d'une seconde extrémité, opposée à la première extrémité (12a), du tube (11).

14. Procédé selon l'une des revendications 1 à 13, dans lequel la plaque (20) est intégrée à un appareil électrique, à l'issue de l'étape c), afin d'assurer une connexion électrique.

## Patentansprüche

1. Verfahren zur Integration eines Wärmeübertragungsrohrs (10) in eine Platte (20), die zur Bildung eines elektrischen Kontakts innerhalb eines oder mehrerer elektrischer Geräte bestimmt ist, wobei das Verfahren umfasst:
a) einen Schritt des Bildens einer von einer Kontaktoberfläche (31c) begrenzten Nut (30) auf einer Hauptfläche (20a) einer Metallplatte (20);
b) einen Schritt des Positionierens eines ersten Abschnitts (11a) eines Rohrs (11) eines Wärmeübertragungsrohrs (10) mit dem Durchmesser D in der Nut (30), wobei sich der erste Abschnitt (11a) ab einem ersten Ende (12a) des Rohrs (11) erstreckt und von einer ersten Oberfläche (11b) begrenzt ist;
c) einen Schritt des Biegens der Platte (20) derart, dass die Nut (30) eingeschlossen und somit der erste Abschnitt (11a) in der Nut (30) eingespannt wird, wobei das Biegen ferner derart durchgeführt wird, dass die Kontaktoberfläche (31c) vollständig im Kontakt mit der ersten Oberfläche (11b) ist, wobei in vorteilhafter Weise der Schritt c) derart ausgeführt wird, dass sich die beiden seitlichen Ränder (31a, 31b) der Nut (30) beim Biegen verformen und den ersten Abschnitt (11a) erfassen.

2. Verfahren nach Anspruch 1, wobei der Schritt c) des Biegens mittels eines Stempels durchgeführt wird, der eine Kraft im Bereich des ersten Abschnitts (11a) ausübt, wobei in vorteilhafter Weise das Ende (101) des Stempels (100) im Kontakt mit dem ersten Abschnitt (11a) bei der Ausführung von Schritt c) eine Form aufweist, die mit dem ersten Abschnitt (11a) konform ist, wobei in noch vorteilhafter Weise bei der Ausführung von Schritt c) die Metallplatte (20) auf einen Halter (110) gestellt wird, der einen V-förmigen Querschnitt aufweist und dessen Öffnung den Biegewinkel der Platte (20) definiert.

3. Verfahren nach Anspruch 1 oder 2, wobei der Biegewinkel θ zwischen 45° und 135° liegt.

4. Verfahren nach einem der Ansprüche 1 bis 3, wobei die Nut (30) eine Breite zwischen dem 1,25- und 2,5-fachen des Durchmessers D aufweist.

5. Verfahren nach einem der Ansprüche 1 bis 4, wobei die Nut (30) eine Tiefe zwischen dem 0,3- und 0,9-fachen des Durchmessers D aufweist.

6. Verfahren nach einem der Ansprüche 1 bis 5, wobei die Nut (30) einen Krümmungsradius ab dem einen und dem anderen der Ränder (31a, 31b) der Nut (30) zwischen dem 0,25- und 2-fachen des Radius des Rohrs (11) aufweist.

7. Verfahren nach einem der Ansprüche 1 bis 6, wobei die Dicke der Metallplatte (20) kleiner als der Durchmesser D ist.

8. Verfahren nach einem der Ansprüche 1 bis 7, wobei die Nut (30) gemäß mindestens einer der Techniken aus: Bearbeiten, Bohren, Wasserstrahlschneiden, Laserschneiden, chemisches Ätzen gebildet wird.

9. Verfahren nach einem der Ansprüche 1 bis 7, wobei die Metallplatte (20) sowie die Nut (30) durch additive Fertigung gebildet werden.

10. Verfahren nach einem der Ansprüche 1 bis 9, wobei vor dem Schritt des Biegens das Rohr (11) eine Füllung aufweist, die ausgelegt ist, um einer Verformung des Rohrs (11) beim Schritt c) des Biegens vorzubeugen, wobei die Füllung ein Gas oder ein Pulver und insbesondere Sand umfasst.

11. Verfahren nach einem der Ansprüche 1 bis 10, wobei ein Fluid, das bestimmt ist, den Transport von Wärme in dem Rohr (11) des Wärmeübertragungsrohrs (10) zu sichern, nach dem Schritt c) des Biegens in das Rohr (11) eingeleitet wird.

12. Verfahren nach einem der Ansprüche 1 bis 9, wobei das Rohr (11) mit einem Fluid gefüllt wird, das bestimmt ist, den Transport von Wärme in dem Rohr (11) des Wärmeübertragungsrohrs (10) zu sichern, in das Rohr (11) vor dem Schritt b) eingeleitet wird, wobei in vorteilhafter Weise das Rohr (11) einen Einsatz (40) in seinem Innenvolumen umfasst, der bestimmt ist, eine Kraft auf die innere Oberfläche des Rohrs (11) auszuüben und jede Verformung des Rohrs (11) bei der Ausführung des Schritts c) zu begrenzen, wobei der Einsatz (40) in vorteilhafterer Weise eine Achse (41) umfasst, die sich gemäß der Erstreckungsrichtung des Rohrs (11) erstreckt und ab der sich gekrümmte Flügel erstrecken, die eine Kraft auf die Innenwand des Rohrs (11) ausüben, wobei in noch vorteilhafterer Weise die Flügel gebogen sind.

13. Verfahren nach einem der Ansprüche 1 bis 12, wobei eine Wärmeverteilungsvorrichtung, insbesondere ein Verteiler mit Flügeln, im Bereich eines zweiten Endes gegenüber dem ersten Ende (12a) des Rohrs (11) angeordnet ist.

14. Verfahren nach einem der Ansprüche 1 bis 13, wobei die Platte (20) nach Abschluss von Schritt c) in ein elektrisches Gerät integriert wird, um eine elektrische Verbindung sicherzustellen.

## Claims

1. Method for integrating a heat pipe (10) to a plate (20) intended to form an electrical contact within one or more electrical devices, the process comprising:
a) a step of forming a groove (30), delimited by a contact surface (31c), on a main face (20a) of a metal plate (20);
b) a step of positioning a first section (11a) of a tube (11) of heat pipe (10), of diameter D, in the groove (30), the first section (11a) extending from a first end (12a) of said tube (11) and is delimited by a first surface (11b);
c) a step of bending the plate (20) so as to close the groove (30) and thus enclose the first section (11a) in said groove (30), the bending being furthermore executed such that the contact surface (31c) is entirely in contact with the first surface (11b), advantageously, step c) is executed such that during bending, the two lateral edges (31a, 31b) of the groove (30) deform and crimp the first section (11a).

2. Method according to claim 1, wherein the bending step c) is executed by means of a punch exerting a force at the first section (11a), advantageously, the end (101) of the punch (100) in contact with the first section (11a) during the execution of step c) has a shape conforming with said first section (11a), even more advantageously during the execution of step c), the metal plate (20) is placed on a support (110) having a V section and whose opening defines the bending angle of said plate (20).

3. Method according to claim 1 or 2, wherein the angle θ of bending is between 45° and 135°.

4. Method according to one of claims 1 to 3, wherein the groove (30) has a width of between 1.25 and 2.5 times the diameter D.

5. Method according to one of claims 1 to 4, wherein the groove (30) has a depth of between 0.3 and 0.9 times the diameter D.

6. Method according to one of claims 1 to 5, wherein the groove (30) has a radius of curvature from one and the other of the edges (31a, 31b) of said groove (30) of between 0.25 and 2 times the radius R of the tube (11).

7. Method according to one of claims 1 to 6, wherein the thickness of the metal plate (20) is less than the diameter D.

8. Method according to one of claims 1 to 7, wherein the groove (30) is formed using at least one of the techniques from: machining, drilling, water jet cutting, laser cutting, chemical etching.

9. Method according to one of claims 1 to 7, wherein the metal plate (20) as well as the groove (30) are formed by additive manufacturing.

10. Method according to one of claims 1 to 9, wherein, before the bending step, the tube (11) has a filling configured to prevent any deformation of the tube (11) during the bending step c), advantageously, the filling comprises a gas or a powder, and in particular sand.

11. Method according to one of claims 1 to 10, wherein a fluid intended to ensure the transport of heat in the tube (11) of the heat pipe (10) is injected into said tube (11) after the bending step c).

12. Method according to one of claims 1 to 9, wherein the tube (11) is filled with a fluid intended to ensure the transport of heat in the tube (11) of the heat pipe (10) is injected into said tube (11) before step b), advantageously, the tube (11) comprises an insert (40) in its internal volume intended to apply a force against the internal surface of the tube (11) and limit any deformation of the tube (11) during the execution of step c), more advantageously, the insert (40) comprises an axis (41) which extends along the direction of extension of the tube (11), and from which curved fins extend which exert a force against the internal wall of the tube (11), even more advantageously the fins are in flexion.

13. Method according to one of claims 1 to 12, wherein a heat dissipation device, in particular a finned heat sink, is arranged at a second end, opposite the first end (12a), of the tube (11).

14. Method according to one of claims 1 to 13, wherein the plate (20) is integrated to an electrical device, at the end of step c), in order to ensure an electrical connection.
